# EUROPÄISCHE PATENTSCHRIFT

(11) **EP 0 948 815 B1**
(45) Veröffentlichungstag und Bekanntmachung des Hinweises auf die Patenterteilung: **13.02.2002**
(21) Anmeldenummer: 97941800.1
(22) Anmeldetag: 21.08.1997
(51) Int. Cl.: H01L 23/498, H05K 3/34, G06K 19/077

(54) **CHIPMODUL UND VERFAHREN ZUR HERSTELLUNG EINES CHIPMODULS**
CHIP MODULE AND MANUFACTURING PROCESS
MODULE DE PUCE ELECTRONIQUE ET MODE DE FABRICATION

(30) Priorität: 23.09.1996 DE 19639025
(43) Veröffentlichungstag der Anmeldung: 13.10.1999
(73) Patentinhaber: Infineon Technologies AG, 81669 München (DE)
(72) Erfinder: FISCHER, Jürgen, D-93180 Deuerling (DE); HEITZER, Josef, D-93090 Bach (DE); HUBER, Michael, D-93152 Nittendorf (DE); PÜSCHNER, Frank, D-93309 Kelheim (DE); STAMPKA, Peter, D-92421 Schwandorf (DE)
(74) Vertreter: Epping, Wilhelm, Dipl.-Ing.
(86) Internationale Anmeldenummer: DE9701805
(87) Internationale Veröffentlichungsnummer: WO9813870

(56) Entgegenhaltungen:
- EP-A- 0 279 683
- EP-A- 0 391 790
- EP-A- 0 408 904
- EP-A- 0 746 188
- DE-A- 4 336 501
- DE-C- 4 431 754
- US-A- 3 517 438
- US-A- 4 991 059
- US-A- 5 270 492
- US-A- 5 421 081
- US-A- 5 455 740
- "Short free-foot design for fine pitch SMT component" IBM TECHNICAL DISCLOSURE BULLETIN., Bd. 32, Nr. 5B, Oktober 1989, NEW YORK US, Seiten 53-54, XP000049151

## Beschreibung

Die Erfindung betrifft ein Chipmodul nach dem Oberbegriff des Anspruches 1 und auf ein Verfahren zur Herstellung eines solchen Chipmoduls nach dem Oberbegriff des Anspruches 13, sowie die Verwendung derartiger Chipmodule in Chipkarten oder ähnlichen Datenträgern, sowie die Verwendung auf bzw. in einer Leiterplatte oder auf bzw. in einem Platinensubstrat.

Chipmodule werden bei der Herstellung von Chipkarten als fertigungstechnisch abgeschlossene Zwischenerzeugnisse produziert und unabhängig zu Enderzeugnissen weiterverarbeitet. Unter einem Chipmodul wird hierbei eine Anordnung gemäß Oberbegriff des Anspruchs 1 verstanden, bei der auf oder in einer Unterlage eine oder mehrere integrierte Halbleiterschaltungen in Form von Chips angeordnet sind, die mit einem auf zumindest einer Seite der Unterlage vorgesehenen Leiterbahnsystem über Verbindungsanschlüsse verbunden sind. Bei einem vorbekannten Chipmodul ist die Unterlage durch einen zumeist aus Epoxy oder dergleichen Kunststoffmaterial gefertigten Träger ausgebildet, auf dem der eigentliche Halbleiterchip montiert wird, und auf welchem sich die meist vergoldeten, in der Regel sechs oder acht Kontaktelemente auf der Außenseite einer üblichen kontaktbehafteten Chipkarte des Formates ID-1, ID-00 oder ID-000 angeordnet sind, über welche eine galvanische Verbindung zu einer externen Lese-Schreibstation für die Energieversorgung und die Datenübertragung zu der in der Chipkarte integrierten Mikrocontrollerschaltung stattfindet, Die Lage der Kontaktelemente in Bezug zum Chipkartenkörper und ihre Größe ist in einer internationalen Norm ISO 7810 bzw. ISO 7816-2 festgelegt. Wegen weiterer Einzelheiten und Merkmale hinsichtlich den Aufbau und die Herstellung eines Chipmoduls und einer Chipkarte wird hiermit ausdrücklich auf Wolfgang Rankl, Wolfgang Effing, Handbuch der Chipkarten, Carl Hanser Verlag, 1995, ISBN 3-446-17993-3 verwiesen und vollinhaltlich Bezug genommen.

Aufgrund von wachsenden, sicherheitsrelevanten Applikationen im Bereich der Chipkarte steigt die Nachfrage nach Mikrocontrollern, welche höchsten Sicherheitsanforderungen genügen. Durch den Einsatz von sogenannten Kryptocontrollern, die vermittels Coprozessoren außerordentliche Rechenleistungen im Hinblick auf das schnelle Abarbeiten asymmetrischer On-Chip-Sicherheitsalgorhythmen erreichen, wird ein sehr hohes Sicherheitsniveau ermöglicht. Durch den dualen Einsatz von Kryptocontrollern sowohl in Chipkarten als auch auf Platinen, beispielsweise bei sogenannten PCMCIA-Steckkarten, Lesesystemen bei Banken und Geldinstituten für die elektrische Kommunikation von Kryptocontrollern und dergleichen Leseeinheiten sind aufgrund der unterschiedlichen Zuverlässigkeitsanforderungen unterschiedliche Gehäuseformen für die Kryptocontrollerschaltungen im Einsatz, welche allerdings wegen der unterschiedlichen Fertigungsprozesse und der verschiedenen Materialien erhebliche Nachteile im Hinblick auf Kosten und logistische Aufwendungen nach sich ziehen.

SMT-fähige Chipgehäuse besitzen speziell geformte Anschlüsse, die eine automatische Bestückung und einen ebenfalls automatischen Lötvorgang erlauben. Bei einer bevorzugten Verbindungstechnik zwischen Halbleiterchip und einer Platine entsprechend der SMT-Technologie wird eine Lötpaste mittels Siebdruck auf die Platine gebracht und anschließend die als SMD-Bauteile gehäusten Halbleiterchips darauf positioniert. Zur Herstellung der Verbindung zwischen Platine und dem Halbleiterchip wird die Platine zur Aufschmelzung des Lotes in einen Ofen verbracht. Hierbei muss sichergestellt werden, dass die Lötverbindung zuverlässig ist und an den definierten Stellen zustande kommt, ohne dass das Lot zerfließt und sich dadurch Kurzschlüsse ergeben bzw. kein guter Kontakt zustande kommt.

Im Gegensatz hierzu besitzen die derzeit verwendeten Chipmodule für Chipkarten relativ großflächige Kontakte, die in erster Linie dazu dienen, einen sicheren Kontakt zu Abtastspitzen eines externen Lesegerätes herzustellen.

Es ist also für unterschiedliche Anwendungsfälle nötig, verschiedene Gehäuse bzw. Chipträger vorzusehen, was zu einer Erhöhung der Herstellungskosten aufgrund verschiedener Fertigungsprozesse, Logistik, Materialien usw. führt.

Aus der DE-A-4431754 C1 ist ein Trägerelement zum Einbau in eine Chipkarte mit einem auf einem leadframe Leiterträger angeordneten und mit dessen Kontaktfahnen elektrisch verbundenen Halbleiterchip bekannt geworden, wobei zumindest der Halbleiterchip und zu dessen Verbindung zu den Kontaktfahnen vorgesehene Bonddrähte von einer Kunststoffmasse derart umgeben sind, dass die Kontaktfahnen als leitende Verbindung zu dem Halbleiterchip aus der Kunststoffmasse herausragen. Die Kontaktfahnen auf einer der Oberflächen der Kunststoffmasse bilden Kontaktflächen, wobei wenigstens zwei der Kontaktfahnen zusätzlich in Verlängerung der Kontaktflächen Anschlüsse für die Enden einer Antennenspule bilden.

Aus der EP-A-0408904 A2 ist ein oberflächenmontierbares Bauelement mit einem Leistungs-Hochfrequenz-Transistor bekannt geworden, welches einen Kunststoff-Formkörper zur Verkapselung der einzelnen Bauelementkomponenten besitzt, wobei die unteren coplanaren Oberflächen der bodenseitig angeordneten Anschlussflächen frei geblieben sind.

Der vorliegenden Erfindung liegt die Aufgabe zugrunde, konstruktive Maßnahmen anzugeben, vermittels welchen ein zunächst für Chipkartenanwendungen gefertigtes Chipmodul auch für den Einsatz in bzw. auf einer externen Platine weiterverarbeitet werden kann.

Diese Aufgabe wird durch ein Chipmodul gemäß Anspruch 1 und ein Verfahren zur Herstellung eines Chipmoduls gemäß Anspruch 11 gelöst. Die Verwendung eines solchen Chipmoduls zur Herstellung von Chipkarten oder ähnlichen Datenträgern ist in Anspruch 20, die Verwendung des Chipmoduls auf bzw. in einer Leiterplatte oder auf bzw. in einem Platinensubstrat in Anspruch 22 angegeben.

Erfindungsgemäß ist vorgesehen, dass die Kontaktelemente für die Oberflächenmontage des Chipmoduls auf der Bestückungsoberfläche einer externen Leiterplatte bzw. einem externen Platinensubstrat ausgebildet sind und mit einem Lötansatz für die dauerhafte Verbindung des Chipmoduls auf der Bestückungsoberfläche der externen Leiterplatte bzw. dem externen Platinensubstrat versehen sind, um eine einfachere Positionierung des Chipmoduls auf dem Anschlussraster der Leiterplatte zu gewährleisten. Hierbei sind die Kontaktelemente des Chipmoduls durch einen vorgefertigten Systemträger ("Leadframe") zur Abstützung des wenigstens einen Halbleiterchips und an wenigstens zwei gegenüberliegenden Seiten des Chipmoduls durch nach außen abgestellte, reihenweise nebeneinanderliegend geführte Anschlüsse für die Oberflächenmontage des Chipmoduls auf der Bestückungsoberfläche einer externen Leiterplatte bzw. einem externen Platinensubstrat gebildet. Ein solcher vorgefertiger Systemträger erfüllt neben der rein elektrischen Funktion in vorteilhafter Weise zugleich die montagetechnischen Forderungen, gibt dem Halbleiterchip einen festen Halt für die Kontaktierung, trägt gleichzeitig die mit den Chipanschlüssen korrespondierenden Anschlussflecken mit gut kontaktierbarer Oberfläche, dient als mechanisch gut definierte Halterung für Transportvorgänge und für die Weiterverarbeitung, und wird im Übrigen auch zur Wärmeableitung oder Wärmeverteilung genutzt. Aufgrund der erfindungsgemäßen Lösung gelingt es, die in einem Chipkartenmodul verwendete integrierte Halbleiterschaltung, insbesondere eine Mikro-bzw. Kryptocontrollerschaltung als elektronisches Bauelement in nur einer Gehäuseform gleichzeitig dem Einsatz als oberflächenmontierbares Bauelement auf die Bestückungsoberfläche einer Platine, einer Steckkarte oder dergleichen Substrat zuzuführen. Die Erfindung bringt folgende wesentliche Vorteile gegenüber dem Stand der Technik mit sich:
- das Chipmodul ist wahlweise für den Einbau in eine Chipkarte oder als oberflächenmontierbares Bauelement verwendbar, wobei die Festlegung dieser Wahlmöglichkeit durch einen relativ einfachen zusätzlichen Bearbeitungsschritt am Ende des Fertigungsprozesses des Chipmoduls, jedoch noch im sogenannten Frontend-Fertigungsbetrieb erfolgen kann;
- durch die Verwendung nur einer Gehäuseform kann der Aufwand bei der Logistik, Lagerhaltung, Transport und dergleichen deutlich verringert werden;
- wegen der Anwendung nur eines einheitlichen Fertigungsprozesses für ein einheitliches Bauelement, welches jedoch für zwei völlig unterschiedliche Anwendungsbereiche verwendbar ist, sind die Herstellkosten wesentlich günstiger als nach den bisher bekannten zwei unterschiedlichen Gehäuseformen und damit unterschiedlichen Fertigungstechnologien;
- für die Fertigung des Chipmoduls auch in seiner Anwendung als oberflächenmontierbares Bauelement sind im Wesentlichen keine Änderungen beim Ablauf des Fertigungsprozesses erforderlich, vielmehr können die bei der Modulmontage bisher durchgeführten Fertigungsschritte im Wesentlichen unverändert genutzt werden;
- das erfindungsgemäße Chipmodul besitzt in seiner Anwendung als oberflächenmontierbares Bauelement eine wesentlich geringere Bauhöhe als die bislang separat hergestellten SMT-fähigen Bauteile;
- für den Einsatz als oberflächenmontierbares Bauelement ist das Chipmodul für alle gängigen Lötverfahren wie beispielsweise Bügel-, Schwall- und Reflowlöten geeignet; hierbei können die Anschlüsse für die Oberflächenmontage des Chipmoduls in Abhängigkeit von der geforderten Qualität der SMT-Bestückung im Hinblick auf Toleranzen, Zuverlässigkeit der Lötstelle, Lötverfahren und dergleichen mit konstruktiv unterschiedlichen Lötansätzen versehen werden;
- nach der endgültigen, abschließenden Formgebung der Kontaktelemente des Chipmoduls kann das Chipmodul auch im Falle der Ausbildung zum oberflächenmontierbaren Bauelement vermittels denselben weiteren Fertigungsschritten (Die-Bonding, Wire-Bonding, Abdecken bzw. Molden, elektrisches Testen, optische Kontrolle und dergleichen Funktionstests) weiterverarbeitet werden, wodurch zugleich Handling und Aussondern defekter Chipmodule erleichtert wird;
- es besteht die Möglichkeit, die bereits vorhandenen Implantationstechniken für den Einbau des Chipmoduls in eine Chipkarte zu nutzen, die bislang bekannten Fertigungstechnologien für die Herstellung einer Chipkarte können somit weiterhin uneingeschränkt Anwendung finden.

Die geometrische Anordnung und Größe der Kontaktelemente richtet sich nach den ISO-Standardvorschriften, insbesondere ISO 7810, die für Chipkarten Verwendung finden, erfüllen jedoch gleichzeitig die an SMT-Bausteine gestellten Anforderungen im Hinblick auf eine ausreichende Lötstopbarriere der Anschlüsse, Temperaturbeständigkeit des Bauelementes und dergleichen. Eine besonders bevorzugte Ausführung zeichnet sich dabei dadurch aus, dass die zu oberflächenmontierbaren Anschlüssen ausgebildeten Kontaktelemente des Systemträgers parallel zueinander verlaufend und in einem vorbestimmten Abstand voneinander ausgebildet sind, welcher Abstand ihrer Mittellinien dem Anschlussraster der auf der Bestückungsoberfläche der externen Leiterplatte bzw. dem externen Platinensubstrat ausgebildeten Anschluss-Stellen entspricht, wobei dieses Anschlussraster insbesondere 1,27 mm oder ein Vielfaches hiervon beträgt. Auf diese Weise eignet sich das erfindungsgemäße Chipmodul auch für die Verarbeitung mit Bestükkungsautomaten, die in der Technologie der Oberflächenmontage (SMT = Surface Mounted Technologie) bei der maschinellen Montage miniaturisierter Bauelemente mit typischen Gehäusebauformen TSOP, SOT, SO, VSO, und dergleichen mit nach außen abgebogenen Lötstummeln im Rastermaß 1,27 mm zum Einsatz gelangen.

Um die Gefahr eines elektrischen Kurzschlusses durch den Einsatz von Lötpaste im Falle einer durch Löten erfolgenden Oberflächenmontage des Chipmoduls auf dem Anschlussraster der Leiterplatte zu minimieren, kann von Vorteil vorgesehen sein, dass der Lötansatz der oberflächenmontierbaren Anschlüsse durch einen quer zur Ebene der Kontaktelemente verlaufenden Abstandhalter ausgebildet ist.

Bei einem konstruktiv besonders einfachen, kostengünstig herzustellenden Chipmodul kann bei einer besonders bevorzugten Ausführung der Erfindung vorgesehen sein, dass die Breite der im Wesentlichen rechteckig ausgebildeten oberflächenmontierbaren Anschlüsse geringfügig kleiner als das Anschlussraster ist.

Zum Schutz des Halbleiterchips vor äußeren mechanischen und chemischen Einflüssen kann eine den Halbleiterchip übergreifende Chipverkapselung aus elektrisch isolierendem Material vorgesehen sein. Damit die vorzugsweise an den freien Enden der Kontaktelemente anzubringenden Lötansätze dem hierbei zum Einsatz gelangenden Werkzeug zugänglich sind, kann von Vorteil vorgesehen sein, dass sich die nach außen abgestellten oberflächenmontierbaren Anschlüsse des Systemträgers in Richtung der Montageebene über die Chipverkapselung hinaus erstrecken.

Die konstruktive Ausbildung der an den freien Enden der Kontaktelemente anzubringenden Lötansätze kann in Abhängigkeit der geforderten Qualität der oberflächenmontierbaren Bestükkung im Hinblick auf einzuhaltende Toleranzen, Zuverlässigkeit der Lötstelle, Lötverfahren und dergleichen unterschiedlich ausgebildet sein. Im einfachsten Fall können die Lötansätze durch eine auf der der Bestückungsoberfläche der Platine zugewandten Seite des nach außen abgestellten Kontaktelementes vorgesehene Vertiefung oder Öffnung gebildet sein, welche vorzugsweise durch Prägen oder chemisches Ätzen gefertigt wird. Weiterhin kann vorgesehen sein, dass der Lötansatz in einer mit entsprechenden Ausschnitten versehenen, mehrfach abgewinkelten Ausformung des nach außen abgestellten Kontaktelementes ausgebildet ist, vorzugsweise durch Stanzen und/oder Biegen.

Im Bereich des Möglichen ist weiterhin, dass aufgrund spezieller Anforderungen bei der Montage des Chipmoduls auf einer Leiterplatte die Anschlüsse bzw. die Kontaktelemente des Moduls über die Modulabdeckung hinaus gezogen sind. Hierbei ist vorgesehen, dass der Lötansatz durch eine die Bauhöhe der Chipverkapselung überragende Abstellung ausgebildet ist.

Bei einer weiterhin bevorzugten Ausführung der Erfindung kann vorgesehen sein, dass der vorgefertigte Systemträger auf seiner dem Halbleiterchip zugewandten Oberfläche eine Isolationsfolie aufweist, welche im Bereich der Lötansätze und/oder im Bereich der Verbindungsanschlüsse mit Öffnungen versehen ist. Die vorzugsweise aus einem Kunststoffmaterial gefertigte Isolationsfolie besitzt hierbei günstigerweise eine Stärke im Bereich von etwa 25 µm bis etwa 200 µm; geeignete Materialien sind beispielsweise Epoxy-Harz, Polyimid, Polyester, Polyethersulfon (PES), Polyparabansäure (PPA), Polyvinylclorid (PVC), Polycarbonat, Kapton und/oder Acrylnitril-ButadienStyrol-Copolymer (ABS) oder dergleichen hochschlagzähes Thermoplastmaterial.

Weitere Merkmale, Vorteile und Zweckmäßigkeiten der Erfindung ergeben sich aus der nachfolgenden Beschreibung von Ausführungsbeispielen der Erfindung anhand der Zeichnung. Es zeigt:
- Figur 1A: eine schematische Schnittdarstellung eines oberflächenmontierbaren Chipmoduls mit einem gestanzten Leadframe mit einem Kunststoff-Stützträger und einem vermittels Globe Top überdeckten Versteifungsrahmen gemäß einem ersten Ausführungsbeispiel der Erfindung;
- Figur 1B: eine schematische Draufsicht des Chipmoduls nach Figur 1A;
- Figur 1C: eine Variante des ersten Ausführungsbeispieles mit einem gestanzten Leadframe und Stützträger in Globe Top-Ausführung;
- Figur 1D: eine schematische Draufsicht des Chipmoduls nach Figur 1C;
- Figur 2A: eine schematische Schnittdarstellung eines oberflächenmontierbaren Chipmoduls mit einem gemoldeten Leadframe gemäß einem zweiten Ausführungsbeispiel der Erfindung;
- Figur 2B: eine schematische Draufsicht des Chipmoduls nach Figur 2A;
- Figur 2C: eine schematische Schnittdarstellung einer Variante des zweiten Ausführungsbeispieles mit einem Leadframe, Kunststoff-Stützträger und Globe Top-Abdeckung;
- Figur 3A: eine schematische Schnittdarstellung eines Chipmoduls gemäß einem dritten Ausführungsbeispiel der Erfindung;
- Figur 3B: eine schematische Draufsicht des Chipmoduls nach Figur 3A;
- Figur 4A: eine schematische Schnittdarstellung eines Chipmoduls gemäß einem vierten Ausführungsbeispiel der Erfindung;
- Figur 4B: eine schematische Draufsicht des Chipmoduls nach Figur 4A;
- Figur 5A: eine schematische Schnittdarstellung eines Chipmoduls gemäß einem fünften Ausführungsbeispiel der Erfindung;
- Figur 5B: eine schematische Draufsicht des Chipmoduls nach Figur 5A;
- Figur 6A: eine schematische Schnittdarstellung eines Chipmoduls gemäß einem sechsten Ausführungsbeispiel der Erfindung;
- Figur 6B: eine schematische Draufsicht des Chipmoduls nach Figur 6A;
- Figur 7A: eine schematische Schnittdarstellung eines Chipmoduls gemäß einem siebten Ausführungsbeispiel der Erfindung;
- Figur 7B: eine schematische Draufsicht des Chipmoduls nach Figur 7A;
- Figur 8A: eine schematische Schnittdarstellung eines Chipmoduls gemäß einem achten Ausführungsbeispiel der Erfindung;
- Figur 8B: eine schematische Draufsicht des Chipmoduls nach Figur 8A;
- Figur 9A: eine schematische Schnittdarstellung eines Chipmoduls gemäß einem neunten Ausführungsbeispiel der Erfindung; und
- Figur 9B: eine schematische Draufsicht des Chipmoduls nach Figur 9A.

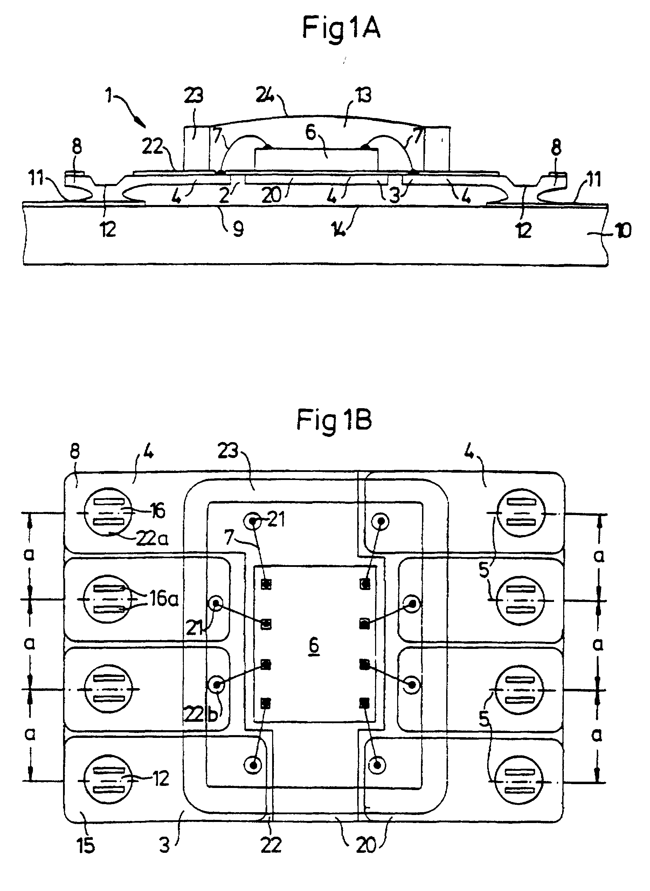

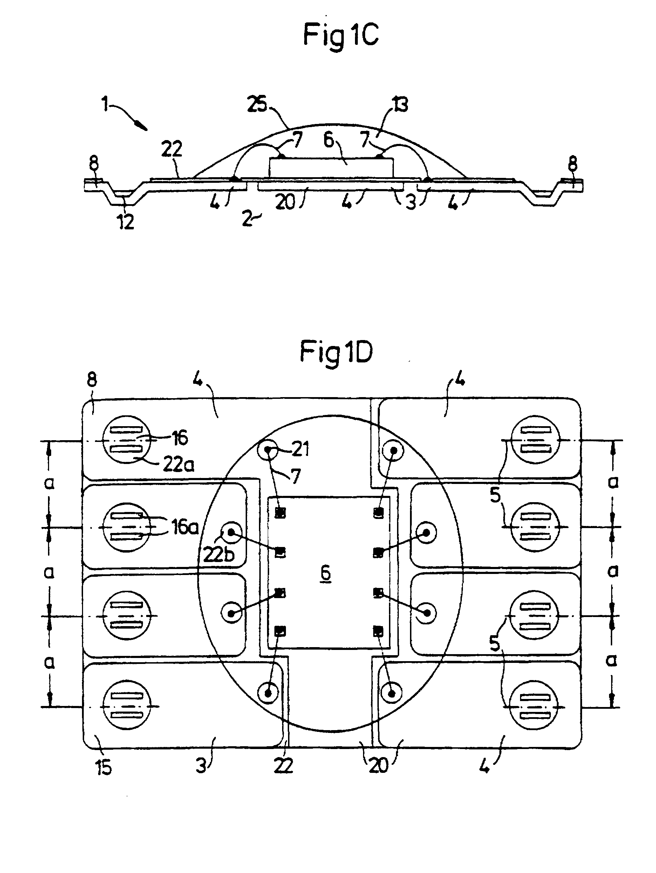

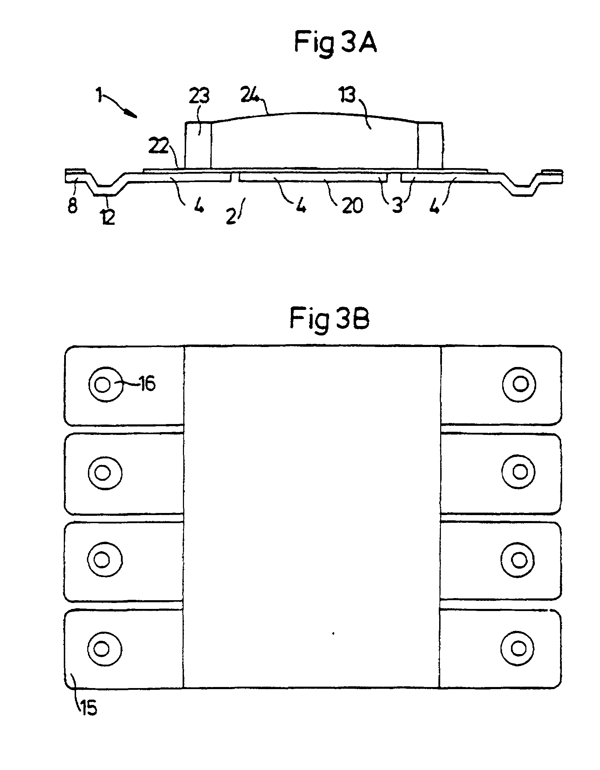

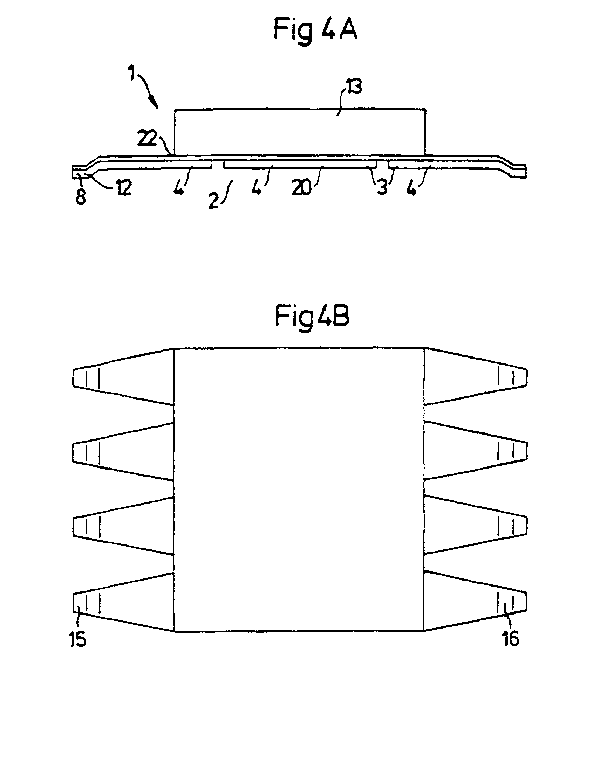

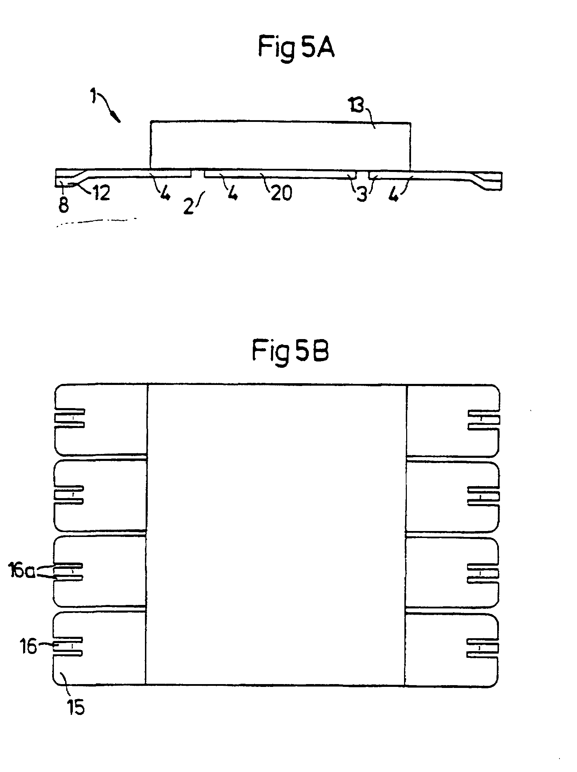

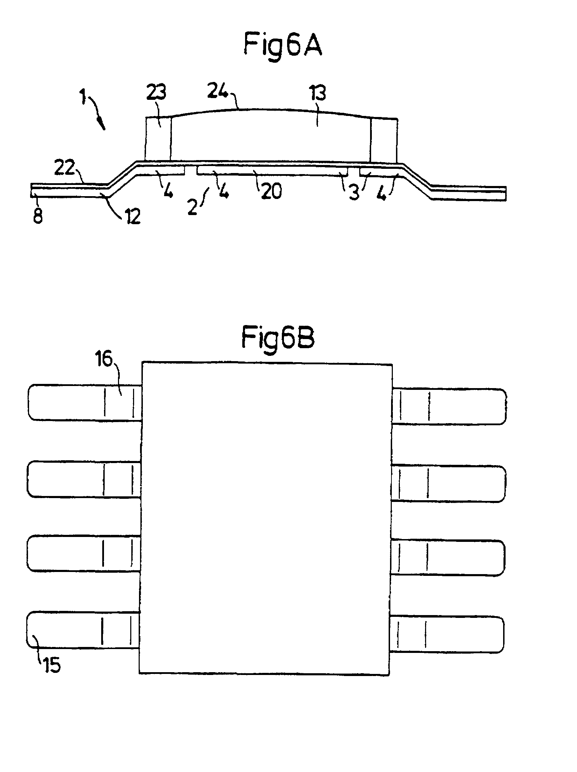

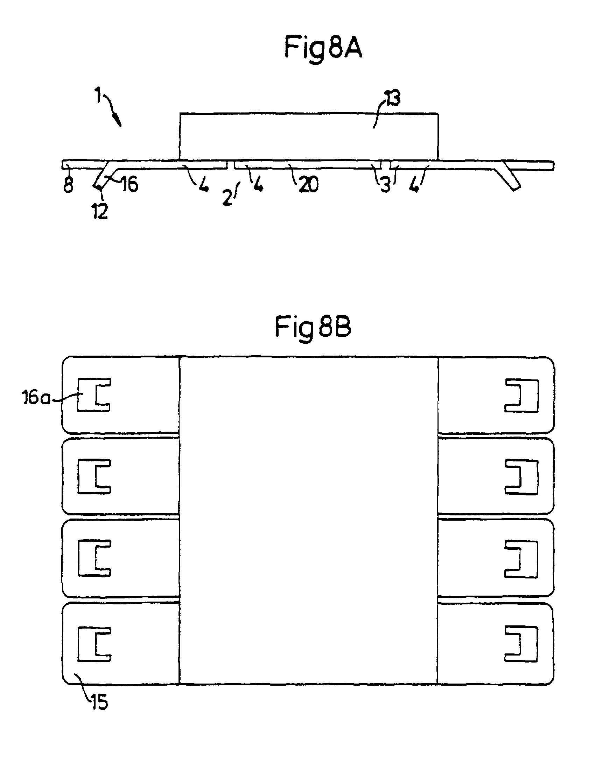

Die in den Figuren 1A bis 9B dargestellten Ausführungsbeispiele der Erfindung umfassen jeweils ein Chipmodul 1 mit einem auf seiner Außenseite 2 angeordneten Kontaktfeld 3 mit mehreren voneinander isolierten, im Wesentlichen flachen Kontaktelementen 4 aus elektrisch leitendem Material, und mit wenigstens einem Halbleiterchip 6 mit einer oder mehreren (in den Figuren nicht näher dargestellten) integrierten Halbleiterschaltungen, welche über Verbindungsanschlüsse in Form von Bonddrähten 7 mit den Kontaktelementen 4 des Kontaktfeldes 3 elektrisch verbunden ist bzw. sind. Die Kontaktelemente 4 des Chipmoduls 1 sind an den beiden gegenüberliegenden Seiten des Chipmoduls 1 durch nach außen abgestellte, reihenweise nebeneinanderliegend geführte Anschlüsse 8 für die Oberflächenmontage des Chipmoduls 1 auf der Bestückungsoberfläche 9 einer externen Leiterplatte 10 bzw. einem externen Platinensubstrat 10 gebildet. Auf der Bestückungsoberfläche 9 der Leiterplatte 10 sind hierbei Lötflecken 11 mit einem bei der Technologie der Oberflächenmontage üblichen Rastermaß von 1,27 mm angeordnet, die als Anschlussstellen für die elektrische und mechanische Verbindung der Kontaktelemente 4 vermittels gängiger Lötverfahren dienen. Die zu den oberflächenmontierbaren Anschlüssen 8 ausgebildeten Kontaktelemente 4 des Chipmoduls 1 sind hierbei parallel zueinander verlaufend und in einem vorbestimmten Abstand a ihrer Mittellinien 5 voneinander ausgebildet, welcher Abstand a wiederum dem Anschlussraster der auf der Bestückungsoberfläche 9 der Leiterplatte 10 ausgebildeten Anschlussstellen 11 entspricht, d.h. a = 1,27 mm. Die zu oberflächenmontierbaren Anschlüssen 8 ausgebildeten Kontaktelemente 4 sind jeweils mit einem Lötansatz 12 für die dauerhafte Verbindung des Chipmoduls 1 auf der Bestückungsoberfläche 9 der Leiterplatte 10 versehen. Zum Schutz des Halbleiterchips 6 vor äußeren mechanischen und chemischen Einflüssen ist eine den Halbleiterchip übergreifende Chipverkapselung 13 aus elektrisch isolierendem Material vorgesehen. Allen in den Figuren dargestellten Ausführungsbeispielen gemeinsam ist hierbei, dass sich die nach außen abgestellten oberflächenmontierbaren Anschlüsse 8 in Richtung der Montageebene 14 über die Chipverkapselung 13 hinaus erstrecken.

Die dargestellten Ausführungsbeispiele unterscheiden sich zum Einen hinsichtlich der konstruktiven Ausbildung der an den freien Enden 15 der Kontaktelemente angebrachten Lötansätze 12, welche in Abhängigkeit der geforderten Qualität der oberflächenmontierbaren Bestückung im Hinblick auf einzuhaltende Toleranzen, Zuverlässigkeit der Lötstelle, Lötverfahren und dergleichen unterschiedlich ausgebildet sind.

Die Ausführungsbeispiele unterscheiden sich weiterhin in Aufbau und Anordnung der den Halbleiterchip 6 schützenden Chipverkapselung 13. Im Rahmen der Erfindung sind an sich beliebige Variationsmöglichkeiten der dargestellten Chipverkapselungs-Anordnungen mit den dargestellten Möglichkeiten zur Ausbildung der Lötansätze denkbar, so dass die explizit dargestellten Ausführungsbeispiele lediglich eine Auswahl der denkbar möglichen Variationen darstellen.

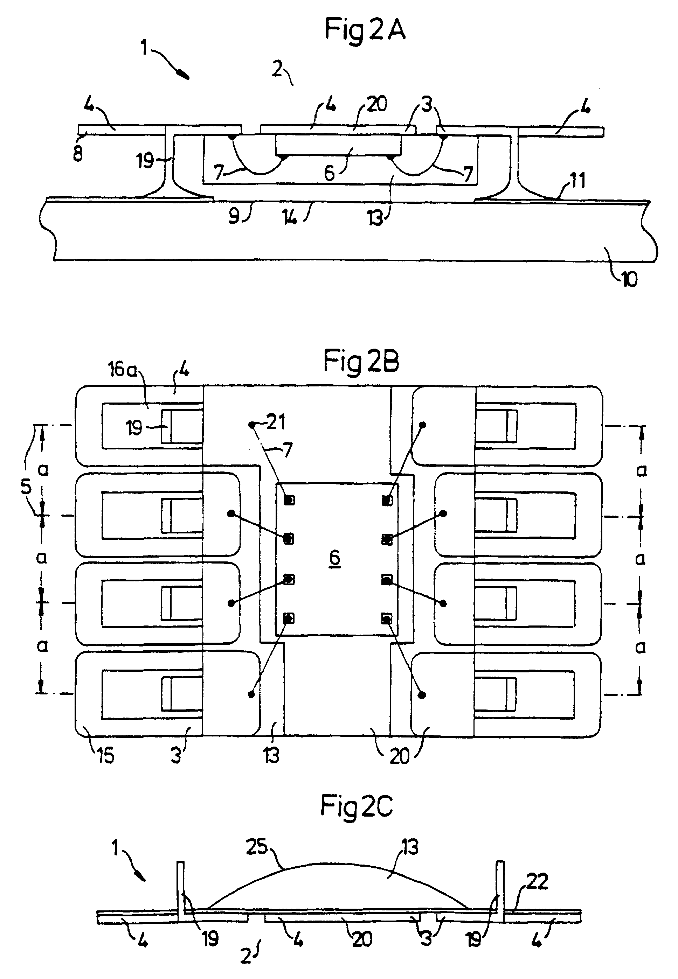

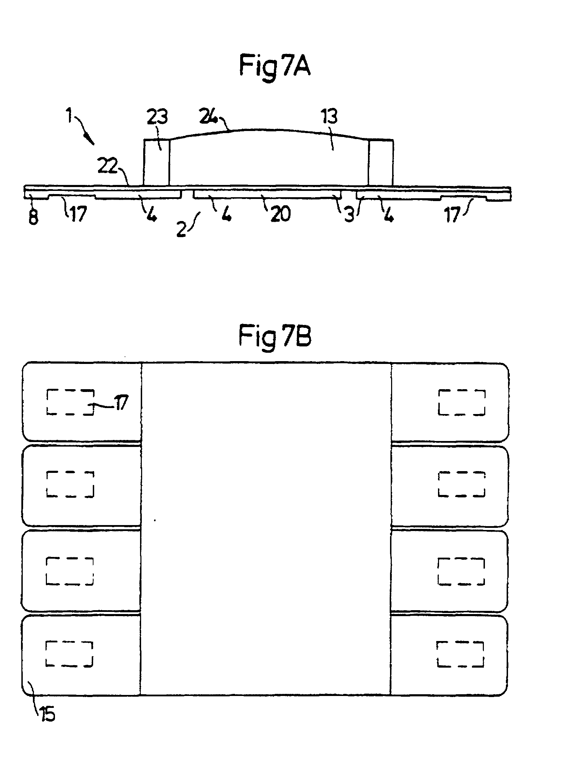

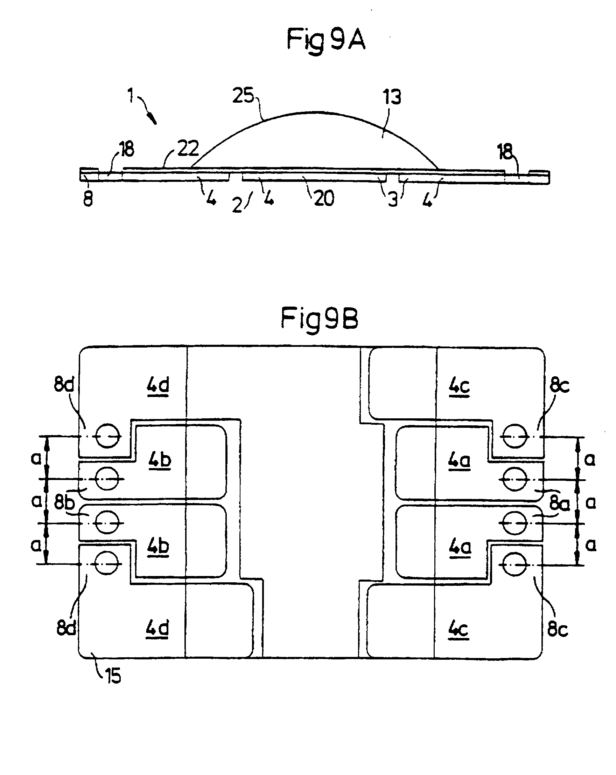

In diesem Sinne sind die Lötansätze 12 bei den Ausführungsbeispielen nach den Figuren 1A, 1B, 1C, 1D, 3A, 3B, 4A, 4B, 5A, 5B, 6A, 6B, 8A, 8B durch eine mit entsprechenden Ausschnitten 16a versehenen, mehrfach abgewinkelten Ausformung 16 des nach außen abgestellten Kontaktelementes 4 ausgebildet, vorzugsweise durch Stanzen und/oder Biegen. Demgegenüber sind die Lötansätze 12 bei dem Ausführungsbeispiel gemäß den Figuren 7A und 7B durch eine auf der der Bestückungsoberfläche 9 der Platine 10 zugewandten Seite des nach außen abgestellten Kontaktelementes 4 vorgesehene Vertiefung 17 gebildet, und entsprechend bei dem Ausführungsbeispiel nach den Figuren 9A und 9B durch eine Öffnung 18 gebildet, welche vorzugsweise durch Prägen oder chemisches Ätzen gefertigt werden. Bei dem Ausführungsbeispiel nach den Figuren 2A, 2B und 2C sind die Lötansätze 12 durch eine die Bauhöhe der Chipverkapselung 13 überragende Abstellung 19 ausgebildet, so dass bei diesem Ausführungsbeispiel das Chipmodul 1 mit nach unten weisendem Halbleiterchip 6 auf der Bestückungsoberfläche 9 der Platine 10 oberflächenmontierbar ist.

Bei sämtlichen in den Figuren dargestellten Ausführungsbeispielen sind die Kontaktelemente 4 bzw. die Anschlüsse 8 erfindungsgemäß durch einen vorgefertigten Systemträger 20 ("Leadframe") aus elektrisch leitendem Material ausgebildet, der zugleich als biegesteife Unterlage zur Abstützung des Halbleiterchips 6 dient und die zur elektrischen Verbindung vermittels der Bonddrähte 7 dienenden Anschlussflecken 21 mit gut kontaktierbarer Oberfläche trägt. Bei den Ausführungsbeispielen nach den Figuren 1A, 1B, 1C, 1D, 2C, 3A, 3B, 4A, 4B, 6A, 6B, 7A, 7B, 9A, 9B ist dem Leadframe 20 ein vorzugsweise aus Kunststoff gefertigter Zwischenträger bzw. eine dünne Isolationsfolie 22 zugeordnet, die im Bereich der Lötansätze 12 und/oder im Bereich der Anschlussflecken 21 mit vorzugsweise ausgestanzten Öffnungen 22a und 22b versehen ist.

Für die Fertigung der Chipverkapselung 13 gibt es innerhalb der konstruktiven Ausgestaltung des erfindungsgemäßen Gegenstandes ebenfalls mehrere Möglichkeiten. So kann die Chipverkapselung 13 unter Einsatz einer geeignet gestalteten Vergussform vermittels einer Vergussmasse gemoldet oder vermittels Dispensens mit einer thermisch oder nach Bestrahlung mit UV-Licht aushärtbaren Masse hergestellt werden. Entsprechende Ausführungsbeispiele sind in den Figuren 2A, 2B, 4A, 4B, 5A, 5B, sowie 8A, 8B dargestellt. Andererseits ist es zur Ausbildung der Chipverkapselung 13 ebenso denkbar, den Halbleiterchip 6 mit einem geeigneten, vorgefertigten Versteifungsrahmen 23 aus Kunststoff, der auf dem Systemträger 20 vorzugsweise vermittels Kleben dauerhaft befestigt wird, vorzusehen, welcher anschließend mit einer sogenannten Globe Top-Abdeckung 24 aus vorzugsweise Epoxy-Kunststoff, UV-härtbarer Kunststoffmasse und dergleichen abgeschlossen wird. Diese Ausführungsvarianten sind in den Figuren 1A, 1B, 3A, 3B, 6A, 6A, 7A, 7B näher dargestellt. Des Weiteren ist es ebenso möglich, den Versteifungsrahmen 23 wegzulassen und den Halbleiterchip 6 und die Bonddrähte 7 unmittelbar mit einer Globe Top-Abdeckung 25 zu umhüllen. Diese Ausführungsformen sind in den Figuren 10, 1D, 2C, 9A, 9B näher dargestellt.

Bei dem Ausführungsbeispiel nach den Figuren 9A und 9B besitzen die Enden 15 der mittleren Anschlüsse 8a und 8b gegenüber den äußeren Anschlüssen 8c und 8d eine etwas geringere Breite; weiterhin sind die Kontaktelemente 4a bis 4d an ihren Randbereichen im Wesentlichen L-förmig und ineinander eingreifend ausgebildet. Diese Gestaltung besitzt den Vorteil, dass unter Einhaltung auch kleinerer Rastermaße a für den Abstand der oberflächenmontierbaren Anschlüsse 8a bis 8d die Kontaktelemente im Sinne des ISO-Standards ISO 7810 ausreichend großflächig gehalten werden können.

## Patentansprüche

1. Chipmodul mit einem auf seiner Außenseite (2) angeordneten Kontaktfeld (3) mit mehreren voneinander isolierten, im Wesentlichen flachen Kontaktelementen (4) aus elektrisch leitendem Material, und mit wenigstens einem Halbleiterchip (6) mit einer oder mehreren integrierten Halbleiterschaltungen, welche über Anschlüsse (8) mit den Kontaktelementen (4) des Kontaktfeldes (3) elektrisch verbunden ist bzw. sind, wobei die Kontaktelemente (4) des Chipmoduls (1) durch einen vorgefertigten Systemträger (20) "Leadframe", zur Abstützung des wenigstens einen Halbleiterchips (6) und an wenigstens zwei gegenüberliegenden Seiten des Chipmoduls (1) durch die nach außen abgestellte, reihenweise nebeneinanderliegend geführte Anschlüsse (8) gebildet sind,
**dadurch gekennzeichnet,**
**dass** die Kontaktelemente (4) für die Oberflächenmontage des Chipmoduls (1) auf der Bestückungsoberfläche (9) einer externen Leiterplatte bzw. einem externen Platinensubstrat (10) ausgebildet sind und mit einem Lötansatz (12) für die dauerhafte Verbindung des Chipmoduls (1) auf der Bestückungsoberfläche (9) der externen Leiterplatte bzw. dem externen Platinensubstrat (10) versehen sind, wobei der Lötansatz (12) der oberflächenmontierbaren Anschlüsse (8) durch einen quer zur Ebene der Kontaktelemente (4) verlaufenden Abstandhalter und/oder durch einen auf der der Bestückungsoberfläche (9) der Platine zugewandten Seite des nach außen abgestellten Kontaktelementes (4) vorgesehene Vertiefung (17) oder Öffnung (18) ausgebildet ist.

2. Chipmodul nach Anspruch 1,
**dadurch gekennzeichnet,**
**dass** die zu oberflächenmontierbaren Anschlüssen (8) ausgebildeten Kontaktelemente (4) des Systemträgers (20) parallel zueinander verlaufend und in einem vorbestimmten Abstand voneinander ausgebildet sind, welcher Abstand (a) ihrer Mittellinien dem Anschlussraster der auf der Bestückungsoberfläche (9) der externen Leiterplatte bzw. dem externen Platinensubstrat (10) ausgebildeten Anschluss-Stellen entspricht, wobei dieses Anschlussraster insbesondere 1,27 mm beträgt.

3. Chipmodul nach einem der Ansprüche 1 oder 2,
**dadurch gekennzeichnet,**
**dass** die Breite der im Wesentlichen rechteckig ausgebildeten oberflächenmontierbaren Anschlüsse (8) geringfügig kleiner als das Anschlussraster ist.

4. Chipmodul nach einem der Ansprüche 1 bis 3,
**dadurch gekennzeichnet,**
**dass** eine wenigstens den Halbleiterchip (6) übergreifende Chipverkapselung (13) aus elektrisch isolierendem Material vorgesehen ist.

5. Chipmodul nach Anspruch 4,
**dadurch gekennzeichnet,**
**dass** sich die nach außen abgestellten oberflächenmontierbaren Anschlüsse (8) des Systemträgers (20) in Richtung der Montageebene (14) über die Chipverkapselung (13) hinaus erstrekken.

6. Chipmodul nach einem der Ansprüche 1 bis 5,
**dadurch gekennzeichnet,**
**dass** der Lötansatz (12) in einer mit entsprechenden Ausschnitten (16a) versehenen, mehrfach abgewinkelten Ausformung (16) des nach außen abgestellten Kontaktelementes (4) ausgebildet ist.

7. Chipmodul nach einem der Ansprüche 1 bis 6,
**dadurch gekennzeichnet,**
**dass** der Lötansatz durch eine die Bauhöhe der Chipverkapselung (13) überragende Abstellung (19) ausgebildet ist.

8. Chipmodul nach einem der Ansprüche 1 bis 7,
**dadurch gekennzeichnet,**
**dass** der vorgefertigte Systemträger (20) auf seiner dem Halbleiterchip (6) zugewandten Oberfläche eine Isolationsfolie aufweist, welche im Bereich der Lötansätze (12) und/oder im Bereich der Verbindungsanschlüsse (8) mit Öffnungen (22a, 22b) versehen ist.

9. Chipmodul nach einem der Ansprüche 4 bis 8,
**dadurch gekennzeichnet,**
**dass** die Chipverkapselung (13) einen den Halbleiterchip (6) umgebenden Versteifungsrahmen (23) besitzt, der mit einer elektrisch isolierenden, den Halbleiterchip (6) überdeckenden Abdeckmasse abgeschlossen ist.

10. Chipmodul nach einem der Ansprüche 4 bis 9,
**dadurch gekennzeichnet,**
**dass** die Chipverkapselung (13) durch eine den Halbleiterchip (6) und/oder die Verbindungsanschlüsse übergreifende Abdeckmasse gebildet ist.

11. Verfahren zur Herstellung eines Chipmoduls mit einem auf seiner Außenseite (2) angeordneten Kontaktfeld (3) mit mehreren voneinander isolierten, im Wesentlichen flachen Kontaktelementen (4) aus elektrisch leitendem Material, und mit wenigstens einem Halbleiterchip (6) mit einer oder mehreren integrierten Halbleiterschaltungen, welche über Verbindungsanschlüsse (8) mit den Kontaktelementen (4) des Kontaktfeldes (3) elektrisch verbunden wird bzw. werden, wobei die Kontaktelemente (4) des Chipmoduls (1) durch einen vorgefertigten Systemträger (20).("Leadframe") zur Abstützung des wenigstens einen Halbleiterchips (6) und an wenigstens zwei gegenüberliegenden Seiten des Chipmoduls (1) durch nach außen abgestellte, reihenweise nebeneinanderliegend geführte Anschlüsse (8) gebildet werden,
**dadurch gekennzeichnet,**
**dass** die Kontaktelemente (4) für die Oberflächenmontage des Chipmoduls (1) auf der Bestückungsoberfläche (9) einer externen Leiterplatte bzw. einem externen Platinensubstrat (10) ausgebildet werden und mit einem Lötansatz (12) für die dauerhafte Verbindung des Chipmoduls (1) auf der Bestückungsoberfläche (9) der externen Leiterplatte bzw. dem externen Platinensubstrat (10) versehen werden, wobei der Lötansatz (12) der oberflächenmontierbaren Anschlüsse (8) durch einen quer zur Ebene der Kontaktelemente (4) verlaufenden Abstandhalter und/oder durch eine auf der-der Bestückungsoberfläche (9) der Platine zugewandten Seite des nach außen abgestellten Kontaktelementes (4) vorgesehene Vertiefung (17) vermittels Ätzen oder eine Öffnung vermittels Stanzen oder Ätzen ausgebildet wird.

12. Verfahren nach Anspruch 11,
**dadurch gekennzeichnet,**
**dass** die zu oberflächenmontierbaren Anschlüssen (8) ausgebildeten Kontaktelemente (4) des Systemträgers (20) parallel zueinander verlaufend und in einem vorbestimmten Abstand voneinander ausgebildet werden, welcher Abstand (a) ihrer Mittellinien dem Anschlussraster der auf der Bestückungsoberfläche (9) der externen Leiterplatte bzw. dem externen Platinensubstrat (10) ausgebildeten Anschluss-Stellen entspricht, wobei dieses Anschlussraster insbesondere 1,27 mm beträgt.

13. Verfahren nach Anspruch 11 oder 12,
**dadurch gekennzeichnet,**
**dass** die Breite der im Wesentlichen rechteckig ausgebildeten oberflächenmontierbaren Anschlüsse (8) geringfügig kleiner als das Anschlussraster wird.

14. Verfahren nach einem der Ansprüche 11 bis 13,
**dadurch gekennzeichnet,**
**dass** eine wenigstens den Halbleiterchip (6) übergreifende Chipverkapselung (13) aus elektrisch isolierendem Material-vorgesehen wird.

15. Verfahren nach Anspruch 14,
**dadurch gekennzeichnet,**
**dass** sich die nach außen abgestellten oberflächenmontierbaren Anschlüsse (8) des Systemträgers (20) in Richtung der Montageebene (14) über die Chipverkapselung (13) hinaus erstrekken.

16. Verfahren nach einem der Ansprüche 14 oder 15,
**dadurch gekennzeichnet,**
**dass** der Lötansatz (12) durch eine die Bauhöhe der Chipverkapselung (13) überragende Abstellung ausgebildet wird.

17. Verfahren nach einem der Ansprüche 11 bis 16,
**dadurch gekennzeichnet,**
**dass** der vorgefertigte Systemträger (20) auf seiner dem Halbleiterchip (6) zugewandten Oberfläche eine Isolationsfolie aufweist, welche im Bereich der Lötansätze (12) und/oder im Bereich der Verbindungsanschlüsse (8) mit Öffnungen (22a, 22b) versehen wird.

18. Verfahren nach einem der Ansprüche 14 bis 17,
**dadurch gekennzeichnet,**
**dass** die Chipverkapselung (13) einen den Halbleiterchip (6) umgebenden Versteifungsrahmen (23) besitzt, der mit einer elektrisch isolierenden, den Halbleiterchip (6) überdeckenden Abdeckmasse abgeschlossen wird.

19. Verfahren nach einem der Ansprüche 14 bis 18,
**dadurch gekennzeichnet,**
**dass** die Chipverkapselung (13) durch eine den Halbleiterchip (6) und/oder die Verbindungsanschlüsse (8) übergreifende Abdeckmasse gebildet wird.

20. Verwendung des Chipmoduls (1) nach einem der Ansprüche 1 bis 10 zur Herstellung von Chipkarten.

21. Chipkarte,
**gekennzeichnet durch**
mindestens ein Chipmodul (1) nach einem der Ansprüche 1 bis 10.

22. Verwendung des Chipmoduls (1) nach einem der Ansprüche 1 bis 10 auf bzw. in einer Leiterplatte oder auf bzw. in einem Platinensubstrat (10).

## Claims

1. Chip module having a contact area (3) arranged on its outer side (2), with a plurality of essentially flat contact elements (4) of electrically conductive material insulated from one another, and having at least one semiconductor chip (6) having one or more integrated semiconductor circuits which are electrically connected to the contact elements (4) of the contact area (3) via terminals (8), **characterized in that** the contact elements (4) for the surface mounting of the chip module (1) are formed on the mounting surface (9) of an external printed circuit board or an external circuit board substrate (10) and are provided with a soldering lug (12) for the permanent connection of the chip module (1) on the mounting surface (9) of the external circuit board or the external board substrate (10), the soldering lug (12) of the surface-mounting terminals (8) being formed by a spacer running transversely with respect to the plane of the contact elements (4) and/or by a depression (17) or opening (18) which is provided on the side of the outwardly offset contact element (4) facing the mounting surface (9) of the circuit board.

2. Chip module according to Claim 1, **characterized in that** the contact elements (4) of the lead frame (20), designed to form surface-mountable terminals (8), are formed such that they run parallel to one another and are at a predetermined distance from one another, which distance (a) between their centre lines corresponds to the connection pattern of the terminal points formed on the mounting surface (9) of the external printed circuit board or the external circuit board substrate (10), this connection pattern being, in particular, 1.27 mm.

3. Chip module according to Claim 1 or 2, **characterized in that** the width of the essentially rectangularly designed surface-mountable terminals (8) is slightly less than the connection pattern.

4. Chip module according to one of Claims 1 to 3, **characterized in that** a chip encapsulation (13) of electrically insulating material, reaching over at least the semiconductor chip (6), is provided.

5. Chip module according to Claim 4, **characterized in that** the outwardly offset surface-mountable terminals (8) of the lead frame (20) extend beyond the chip encapsulation (13) in the direction of the mounting plane (14).

6. Chip module according to one of Claims 1 to 5, **characterized in that** the soldering lug (12) is formed in a multiply angled shaping (16) of the outwardly offset contact element (4) provided with corresponding cutouts (16a).

7. Chip module according to one of Claims 1 to 6, **characterized in that** the soldering lug is formed by an offset (19) rising above the overall height of the chip encapsulation (13).

8. Chip module according to one of Claims 1 to 7, **characterized in that** the prefabricated lead frame (20) has on its surface facing the semiconductor chip (6) an insulation film which is provided with openings (22a, 22b) in the region of the soldering lugs (12) and/or in the region of the connection terminals (8).

9. Chip module according to one of Claims 4 to 8, **characterized in that** the chip encapsulation (13) has a reinforcing frame (23) which surrounds the semiconductor chip (6) and is closed off by an electrically insulating covering compound covering the semiconductor chip (6).

10. Chip module according to one of Claims 4 to 9, **characterized in that** the chip encapsulation (13) is formed by a covering compound reaching over the semiconductor chip (6) and/or the connection terminals.

11. Method of producing a chip module having a contact area (3) arranged on its outer side (2), with a plurality of essentially flat contact elements (4) of electrically conductive material insulated from one another, and having at least one semiconductor chip (6) having one or more integrated semiconductor circuits which are electrically connected to the contact elements (4) of the contact area (3) via connection terminals (8), the contact elements (4) of the chip module (1) being formed by a prefabricated lead frame (20) for supporting the at least one semiconductor chip (6) and, on at least two opposing sides of the chip module (1), by outwardly offset terminals (8) arranged in rows next to one another, **characterized in that** the contact elements (4) for the surface mounting of the chip module (1) are formed on the mounting surface (9) of an external printed circuit board or an external circuit board substrate (10) and are provided with a soldering lug (12) for the permanent connection of the chip module (1) on the mounting surface (9) of the external circuit board or the external board substrate (10), the soldering lug (12) of the surface-mounting terminals (8) being formed by a spacer running transversely with respect to the plane of the contact elements (4) and/or by a depression (17), by means of etching, or an opening, by means of punching or etching, which is provided on the side of the outwardly offset contact element (4) facing the mounting surface (9) of the circuit board.

12. Method according to Claim 11, **characterized in that** the contact elements (4) of the lead frame (20), designed to form surface-mountable terminals (8), are formed such that they run parallel to one another and are at a predetermined distance from one another, which distance (a) between their centre lines corresponds to the connection pattern of the terminal points formed on the mounting surface (9) of the external printed circuit board or the external circuit board substrate (10), this connection pattern being, in particular, 1.27 mm.

13. Method according to Claim 11 or 12, **characterized in that** the width of the essentially rectangularly designed surface-mountable terminals (8) is slightly less than the connection pattern.

14. Method according to one of Claims 11 to 13, **characterized in that** a chip encapsulation (13) of electrically insulating material, reaching over at least the semiconductor chip (6), is provided.

15. Method according to Claim 14, **characterized in that** the outwardly offset surface-mountable terminals (8) of the lead frame (20) extend beyond the chip encapsulation (13) in the direction of the mounting plane (14).

16. Method according to Claim 14 or 15, **characterized in that** the soldering lug (12) is formed by an offset rising above the overall height of the chip encapsulation (13).

17. Method according to one of Claims 11 to 16, **characterized in that** the prefabricated lead frame (20) has on its surface facing the semiconductor chip (6) an insulation film which is provided with openings (22a, 22b) in the region of the soldering lugs (12) and/or in the region of the connection terminals (8).

18. Method according to one of Claims 14 to 17, **characterized in that** the chip encapsulation (13) has a reinforcing frame (23) which surrounds the semiconductor chip (6) and is closed off by an electrically insulating covering compound covering the semiconductor chip (6).

19. Method according to one of Claims 14 to 18, **characterized in that** the chip encapsulation (13) is formed by a covering compound reaching over the semiconductor chip (6) and/or the connection terminals.

20. Use of the chip module (1) according to one of Claims 1 to 10 for producing chip cards.

21. Chip card, **characterized by** at least one chip module (1) according to one of Claims 1 to 10.

22. Use of the chip module (1) according to one of Claims 1 to 10 on or in a printed circuit board or on or in a circuit board substrate (10).

## Revendications

1. Module de puce comprenant un champ (3) de contact disposé sur sa face (2) extérieure et ayant plusieurs éléments (4) de contact en matériau électriquement conducteur sensiblement plats et isolés les uns des autres, et au moins une puce (6) à semi-conducteur ayant un circuit intégré à semi-conducteur ou plusieurs circuits intégrés à semi-conducteur, qui est ou sont reliés électriquement par des bornes (8) aux éléments (4) de contact du champ (3) de contact, les éléments (4) de contact du module (1) de puce étant formés par un support (20) de système préfabriqué, "Leadframe", destiné à soutenir la au moins une puce (6) à semi-conducteur et sur au moins deux côtés opposés du module (1) de puce, par les bornes (8) en saillie vers l'extérieur et guidées côte à côte rangée par rangée,
**caractérisé,**
**en ce que** les éléments (4) de contact sont constitués pour le montage en surface du module (1) de puce sur la surface (9) d'implantation d'une plaquette à circuit imprimé extérieure ou d'un substrat (10) extérieur servant de platine et sont munis d'un embout (12) de brasure pour la liaison permanente du module (1) de puce sur la surface (9) d'implantation de la plaquette à circuit imprimé extérieure ou sur le substrat (10) extérieur servant de platine, l'embout (12) de brasure des bornes (8), qui peuvent être montées en surface, étant constitué par un espaceur s'étendant transversalement au plan des éléments (4) de contact et/ou par une cavité (17) ou une ouverture (18), prévue du côté de l'élément (4) de contact en saillie vers l'extérieur, qui est tourné vers la surface (9) d'implantation de la platine.

2. Module de puce suivant la revendication 1, **caractérisé en ce que** les éléments (4) de contact du support (20) de système, qui sont constitués en bornes (8) pouvant être montées en surface, s'étendent parallèlement entre eux et à une distance prescrite les uns des autres, laquelle distance (a) entre leurs lignes médianes correspond à la trame des points de borne constituée sur la surface (9) d'implantation de la plaquette à circuit imprimé extérieure ou du substrat (10) extérieur servant de platine, cette trame de borne étant notamment de 1,27 mm.

3. Module de puce suivant l'une des revendications 1 ou 2, **caractérisé en ce que** la largeur des bornes (8) pouvant être montées en surface, de forme sensiblement rectangulaire, est légèrement plus petite que la trame de borne.

4. Module de puce suivant l'une des revendications 1 à 3, **caractérisée en ce qu'**il est prévu un enrobage (13) de puce recouvrant au moins la puce (6) à semi-conducteur et constitué en une matière électriquement isolante.

5. Module à puce suivant la revendication 4, **caractérisé en ce que** les bornes (8), qui peuvent être montées en surface et qui sont en saillie vers l'extérieur du support (20) de système, s'étendent en direction du plan (14) de montage au-dessus de l'enrobage (13) de la puce.

6. Module à puce suivant l'une des revendications 1 à 5, **caractérisée en ce que** l'embout (12) de brasure est constitué par une conformation (16) de l'élément (4) de contact en saillie vers l'extérieur, coudée plusieurs fois et munie de découpes (16a) adéquates.

7. Module à puce suivant l'une des revendications 1 à 6, **caractérisé en ce que** l'embout de brasure est constitué par une saillie (19) dépassant du niveau de l'enrobage (13) de puce.

8. Module à puce suivant l'une des revendications 1 à 7, **caractérisé en ce que** le support (20) de système préfabriqué comporte sur sa surface tournée vers la puce (6) à semi-conducteur une feuille isolante, qui est munie dans la partie de l'embout (12) de brasure et/ou dans la partie des bornes (8) de connexion, d'ouvertures (22a, 22b).

9. Module à puce suivant l'une des revendications 4 et 8, **caractérisé en ce que** l'enrobage (13) de la puce a un cadre (23) de raidissement entourant la puce (6) à semi-conducteur et fermé par une composition de recouvrement isolante électriquement et recouvrant la puce (6) à semi-conducteur.

10. Module à puce suivant l'une des revendications 4 à 9, **caractérisé en ce que** l'enrobage (13) de puce est formé par une composition de recouvrement recouvrant la puce (6) à semi-conducteur et/ou les bornes de connexion.

11. Procédé de fabrication d'un module de puce ayant un champ (3) de contact disposé sur sa face (2) extérieure et ayant plusieurs éléments (4) de contact en matériau électriquement conducteur sensiblement plats et isolés les uns des autres, et au moins une puce (6) à semi-conducteur ayant un circuit intégré à semi-conducteur ou plusieurs circuits intégrés à semi-conducteur, qui est ou sont reliés électriquement par des bornes (8) aux éléments (4) de contact du champ (3) de contact, les éléments (4) du contact du module (1) de puce étant formés par un support (20) de système préfabriqué, "Leadframe", destiné à soutenir la au moins une puce (6) à semi-conducteur et sur au moins deux côtés opposés du module (1) de puce, par les bornes (8) en saillie vers l'extérieur et guidées côte à côte rangée par rangée
en ce que les éléments (4) de contact sont constitués pour le montage en surface du module (1) de puce sur la surface (9) d'implantation d'une plaquette à circuit imprimée extérieure ou d'un substrat (10) extérieur servant de platine, et sont munis d'un embout (12) de brasure pour la liaison permanente du module (1) de puce sur la surface (9) d'implantation de la plaquette à circuit imprimé extérieure ou du substrat (10) extérieur servant de platine, l'embout (12) de brasure des bornes (8), qui peuvent être montées en surface, étant formé par un espaceur s'étendant transversalement au plan des éléments (4) de contact et/ou, par une cavité ménagée du côté de l'élément (4) de contact en saillie vers l'extérieur, qui est tourné vers la surface (9) d'implantation de la platine, cette cavité étant obtenue par attaque chimique ou par une ouverture obtenue par découpe ou attaque chimique.

12. Procédé suivant la revendication 11, **caractérisé en ce que** les éléments (4) de contact du support (20) de système, qui sont constitués en bornes (8) pouvant être montées en surface, s'étendent parallèlement entre eux et à une distance prescrite les uns des autres, laquelle distance (a) entre leurs lignes médianes correspond à la trame des points de bome constituée sur la surface (9) d'implantation de la plaquette à circuit imprimé extérieure ou du substrat (10) extérieur servant de platine, cette trame de borne étant notamment de 1,27 mm.

13. Procédé suivant la revendication 11 ou 12, **caractérisé en ce que** la largeur des bornes (8) pouvant être montées en surface, de forme sensiblement rectangulaire, est légèrement plus petite que la trame de borne.

14. Procédé suivant l'une des revendications 11 à 13, **caractérisée en ce qu'**il est prévu un enrobage (13) de puce recouvrant au moins la puce (6) à semi-conducteur et constitué en une matière électriquement isolante.

15. Procédé suivant la revendication 14, **caractérisé en ce que** les bornes (8), qui peuvent être montées en surface et qui sont en saillie vers l'extérieur du support (20) de système, s'étendent en direction du plan (14) de montage au-dessus de l'enrobage (13) de la puce.

16. Procédé suivant l'une des revendications 14 ou 15, **caractérisé en ce que** l'embout (12) de brasure est constitué par une saillie dépassant du niveau de l'enrobage (13) de la puce.

17. Procédé suivant l'une des revendications 11 à 16, **caractérisé en ce que** le support (20) de système préfabriqué comporte sur sa surface tournée vers la puce (6) à semi-conducteur une feuille isolante, qui est munie dans la partie du tenon (12) de brasure et/ou dans la partie des bornes (8) de connexion, d'ouvertures (22a, 22b).

18. Procédé suivant l'une des revendications 14 à 17, **caractérisé en ce que** l'enrobage (13) de la puce a un cadre (23) de raidissement entourant la puce (6) à semi-conducteur et fermé par une composition de recouvrement isolante électriquement et recouvrant la puce (6) à semi-conducteur.

19. Procédé suivant l'une des revendications 14 à 18, **caractérisé en ce que** l'enrobage (13) de puce est formé par une composition de recouvrement recouvrant la puce (6) à semi-conducteur et/ou les bornes de connexion.

20. Utilisation du module (1) de puce suivant l'une des revendications 1 à 10 pour fabriquer les cartes à puce.

21. Carte à puce **caractérisée par** au moins un module (1) de puce suivant l'une des revendications 1 à 10.

22. Utilisation du module (1) de puce suivant l'une des revendications 1 à 10 sur ou dans une plaquette à circuit imprimé ou sur ou dans un substrat (10) servant de platine.
